# EUROPEAN PATENT SPECIFICATION

(11) **EP 4 407 468 B1**
(45) Date of publication and mention of the grant of the patent: **11.11.2026**
(21) Application number: 23153072.6
(22) Date of filing: 24.01.2023
(51) Int. Cl.: G06F 11/3668, G06F 30/20, G05B 17/02

(54) **COMPUTER-IMPLEMENTED METHOD FOR GENERATING AN INTEGRATION TEST MODEL**
COMPUTERIMPLEMENTIERTES VERFAHREN ZUR ERZEUGUNG EINES INTEGRATIONSTESTMODELLS
PROCÉDÉ MIS EN OEUVRE PAR ORDINATEUR POUR GÉNÉRER UN MODÈLE DE TEST D'INTÉGRATION

(43) Date of publication of application: 31.07.2024
(73) Proprietor: Siemens Aktiengesellschaft, 80333 München (DE)
(72) Inventor: Rothbauer, Stefan, 86156 Augsburg (DE); Przigoda, Nils, 38170 Gross Vahlberg (DE); Schrader, Jan-Ole, 38116 Braunschweig (DE); Storck, Stephan, 83075 Bad Feilnbach - Au (DE)
(74) Representative: Siemens Patent Attorneys

(56) References cited:
- EP-A1- 4 050 489
- SHIN KI-WOOK ET AL: "Model-based automatic test case generation for automotive embedded software testing", INTERNATIONAL JOURNAL OF AUTOMOTIVE TECHNOLOGY, THE KOREAN SOCIETY OF AUTOMOTIVE ENGINEERS, HEIDELBERG, vol. 19, no. 1, 3 October 2017 (2017-10-03), pages 107 - 119, XP036331994, ISSN: 1229-9138, [retrieved on 20171003], DOI: 10.1007/S12239-018-0011-6
- BAJER MARCIN ET AL: "Embedded software testing in research environment. A practical guide for non-experts", 2015 4TH MEDITERRANEAN CONFERENCE ON EMBEDDED COMPUTING (MECO), IEEE, 14 June 2015 (2015-06-14), pages 100 - 105, XP033190757, ISBN: 978-1-4799-8999-7, [retrieved on 20150806], DOI: 10.1109/MECO.2015.7181877

## Description

### 1. Technical field

The present invention relates to a computer-implemented method for generating an integration test model. Further, the invention relates to a corresponding computer program product and technical system.

### 2. Prior art

The importance of safety-critical systems in many application domains of embedded systems, such as aerospace, railway, health care, automotive and industrial automation is continuously growing. Thus, along with the growing system complexity, also the need for safety assessment as well as its effort is increasing drastically to guarantee the high-quality demands in these application domains.

A goal of the safety assessment process is to identify all failures that cause hazardous situations and to demonstrate that their probabilities are sufficiently low. In the application domains of safety-critical systems the safety assurance process is defined by the means of safety standards, such as IEC61508 or others.

Traditionally, the analysis of a system in terms of safety consists of bottom-up safety analysis approaches, such as Failure Mode and Effect Analysis (FMEA), and top-down approaches, such as Fault Tree Analysis (FTA) to identify failure modes, their causes, and effects with impact on the system safety. With Component Fault Trees (CFTs) there is a model- and component-based methodology for FTA, which supports a modular and compositional safety analysis strategy.

In particular, for safety-critical systems, there are regulatory requirements to show that the safety-related functions or safety-relevant functionalities perform the intended functionality correctly and that all relevant hazards are dealt by the technical system adequately.

The railway infrastructure is a highly complex technical system, which consists of many technical components that interact with each other by means of e.g. asynchronous communication. Different techniques can be used for the asynchronous communication depending on e.g. the domain and the technologies used, like messages, signals or telegrams. Each technical component reacts to a received telegram as defined in it's control logic and depending on the internal state of the technical component and states of other technical components, which can be known from the telegrams content.

Some characteristics of the railway infrastructure are listed in the following:
- the system logic is captured in complex and interdependent sequence charts or domain specific types of control logic charts)
- the system behavior and the control flow are distributed over various technical components
- the technical components of the technical system interact via telegrams
- the communication flow (e.g. telegrams) defines the behavior on system level
- the logic of the technical components can be hard to understand (only in context with other technical components and when considering all internal actions triggered on the same technical component)
- the operational characteristics are not easy to verify because of the distribution of the logic over many technical components which can trigger further actions within the technical components
- the railway infrastructure is a safety-critical system in the sense that errors can lead to e.g. high damages, such as collision of trains and to e.g. operational problems, such as trains cannot pass

Testing a railway infrastructure remains a challenging task. Currently, tests are specified based on expert knowledge. The resulting coverage of the respective logic control charts is measured. If the required coverage is not reached, further expert analysis will be performed to conclude which additional tests are required. This is a manual and hence time-consuming iterative process, which needs to be repeated every time the system logic is changed.

It is therefore an objective of the invention to provide a computer-implemented method for generating an integration test model, which is more efficient and more reliable.

SHIN KI-WOOK ET AL: "Model-based automatic test case generation for automotive embedded software testing",INTERNATIONAL JOURNAL OF AUTOMOTIVE TECHNOLOGY, THE KOREAN SOCIETY OF AUTOMOTIVE ENGINEERS, HEIDELBERG, vol. 19, no. 1, 3 October 2017 (2017-10-03), pages 107-119, is mentioned as background art.

### 3. Summary of the invention

This problem is according to one aspect of the invention solved by a computer-implemented method according to claim 1.

Accordingly, the invention is directed to a computer-implemented method for generating the integration test model. In the first steps, the input data is provided, namely the one or more communication means, the one or more system configurations and the test data model. The input data can be received and/or transmitted via one or more interfaces of a technical unit, wherein the technical unit can be designed as any computing unit.

Thereby, the technical components of the technical system communicate or exchange information, preferably by means of asynchronous communication, preferably telegrams. Preferably, the technical system is a safety-critical system, preferably a railway infrastructure or railway infrastructure system. Further, the technical components are components or elements of the technical system. Preferably, the technical components are physical components that assume specific tasks, representing the physical state of the technical components such as a crossing, track segment or keylock.

The telegrams are the way the technical components communicate with each other, e. g. over network or bus systems. The telegrams are sent and received by a technical component at its defined ports.

The behaviour of the technical components is defined by one or more control logic charts. These control logic charts define which reaction a received telegram will trigger within the technical component, which other telegrams are sent as a result and whether the telegram is stopped or forwarded at a defined external interface (port). In other words, the behavior of the technical components of the technical system is described by system models, which are designed as control logic charts. The control logic charts can be created by means of the tool "Grace".

The behavior of the technical components can be described depending on the content of the telegram and/or one or more internal states at arrival of a telegram. Exemplary consequential actions are the adaptation of an internal state, the triggering of an internal trigger, transmitting additional or further telegrams via external ports to other technical components.

The technical system comprises the technical components which are connected in a defined system configuration. The system configuration defines the connection of each external interface to respective interfaces of other technical components. For integration testing, a specific system configuration is used to resemble a desired test environment. The test environment allows to test the interactions of the relevant technical components in its specific system configuration. For example, the receiving unit or receiver of the telegram is specified, e.g. in the case that a technical component transmits a telegram at a port. The system configuration for the test environment is designed in a way that it allows to perform the tests for the respective integrations scenario.

For example, considering a keylock-ring with three technical components over boarders of control areas, which are assigned to an area control computer as an example, can be tested only with a test environment that provides three technical components in distinct control areas.

The test data model describes the data structure and data values, which are required to stimulate the system and verify the system responses from a testing point of view. It should include all relevant information to govern test execution in the relevant cases. Test data modeling uses the category partition method, therefore the test data model defines data categories and for each category possible choices (data values). This reduces the possibly very large input space to a more manageable amount, while not reducing the effectiveness of the test cases.

The integration test model is generated based on the input data. Importantly, the information of the one or more respective control logic charts is considered with regard to the one or more communication means during generation. Examples for the information considered from control logic charts in building the integration test model include further communication means triggered on the components ports, internal state and variable changes or internal triggers leading to further changes of the components internal state.

The resulting integration test model is provided as output. The generated integration test model is preferably the basis to generate the integration test cases and executable test scripts for automated testing.

The present invention ensures that the integration test model is generated in an efficient and reliable manner. The resulting integration test model is also reliable since all relevant information for testing, such as system configuration, is incorporated and integrated in the integration test model. Hence, different integration scenarios are covered by the integration test model. The reliability of the resulting executable tests depending on the integration test model and hence testing can be significantly improved.

Moreover, the advantage of the present invention is that defined test environments for integration testing are generated. This way it can be ensured systematically that all relevant system properties with regard to the integration of technical components are tested.

Moreover, test goals are efficiently and systematically achieved by focused testing of integration scenarios, as opposed to testing integration via system level tests.

Moreover, the systematic coverage of all interfaces can be ensured via defined communication methods.

Moreover, the internal and external communication is advantageously considered. The communication means are considered in the manner that for each control logic chart of a technical component, each port and all defined communication means on that port are considered. Further, possible triggers for internal communication are considered.

A further advantage is that the executable tests and hence according test code are efficiently generated. Hence, the effort for generating tests to achieve this goal is significantly reduced. This is particularly valuable in complex technical systems where a large number of tests is required to cover the technical systems functionality sufficiently.

Moreover, the executable tests can be generated reusing test steps, test setup and test teardown.

In an aspect providing the at least one system configuration as at least one test environment comprises
- Providing a plurality of test environments by generating a respective test environment for each system configuration of a plurality of system configurations;
- Providing one test environment for a plurality of system configurations; or
- Providing at least one configured test environment considering at least one requirement.

Accordingly, the system configuration can be designed in a flexible manner e.g. depending on the user requirements, the underlying technical system, the use case and/or any other criteria.

In a further aspect the information is information of a control flow.

In a further aspect the generated integration test model describes all possible sets of telegrams (both external and internal telegrams) resulting from the triggering telegram with the context of the integration test (the respective test environment).

In a further aspect considering information of the respective control logic chart, comprises
- Starting with the at least one communication means communicated by the at least one technical component;
- Following the at least one communication means, at least one triggered internal trigger and/or at least one external communication means until all distinct sets of telegrams are created in the given context.

In a further aspect, the computer-implemented method further comprises
- Analysing the integration test model; and/or
- Adapting the integration test model.

In a further aspect, the computer-implemented method further comprises generating at least one executable test according to at least one test goal based on the integration test model.

In a further aspect, the computer-implemented method further comprises executing the at least one executable test in the at least one test environment to generate at least one test result. Accordingly, a technical system, such as the railway infrastructure with the plurality of technical components is tested by means of executing the executable tests. Testing a technical system may particularly include testing regarding functional behavior of the technical system as well as regarding safety of the technical system.

In a further aspect, the computer-implemented method further comprises
- triggering at least one measure depending on the at least one test result to reach a safe state;
- storing the at least one test result in a storage unit;
   and/or
- transmitting the at least one test result and/or any other related notification to a computing unit.

Accordingly, the input data, data of intermediate method steps and/or resulting output data in form of the integration test model can be further handled. One or more actions can be performed. The action can be equally referred to as measure.

These actions can be performed by one or more technical units, such as computing unit or robot unit. The actions can be performed gradually or simultaneously. Actions include e.g. storing and processing steps. The advantage is that appropriate actions can be performed in a timely manner.

According to a preferred embodiment, the integration test model is analyzed. The integration test model is released for generating executable tests depending on the analysis. Alternatively, the integration test model is adapted and released after adaptation.

Preferably, the integration test model is used to generate one or more executable tests, preferably after the release. The tests are then executed in the test environment resulting in test results. The test results can be further handled or processed. For example, the release of a key lock is requested. However, the point is misplaced. In this case, the request is denied and the release is prevented.

A further aspect of the invention is a computer program product directly loadable into an internal memory of a computer, comprising software code portions for performing the steps according to any one of the preceding claims when said computer program product is running on a computer.

A further aspect of the invention is a technical system for performing the aforementioned computer-implemented method.

### 4. Short description of the drawings

In the following detailed description, presently preferred embodiments of the invention are further described with reference to the following figures:
- Fig. 1: illustrates a flowchart of the method according to the invention.
- Fig. 2: illustrates a schematic diagram of the input and output data according to an embodiment.

### 5. Detailed description of preferred embodiments

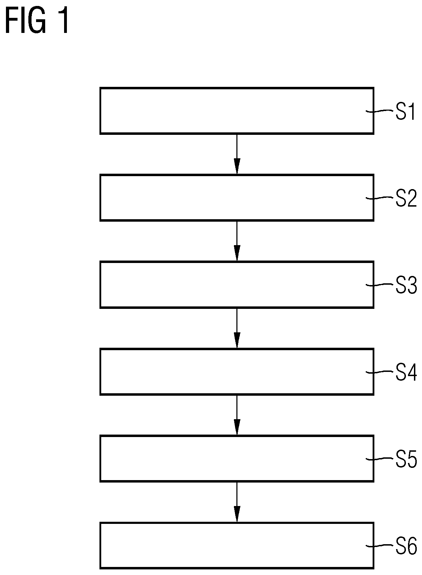

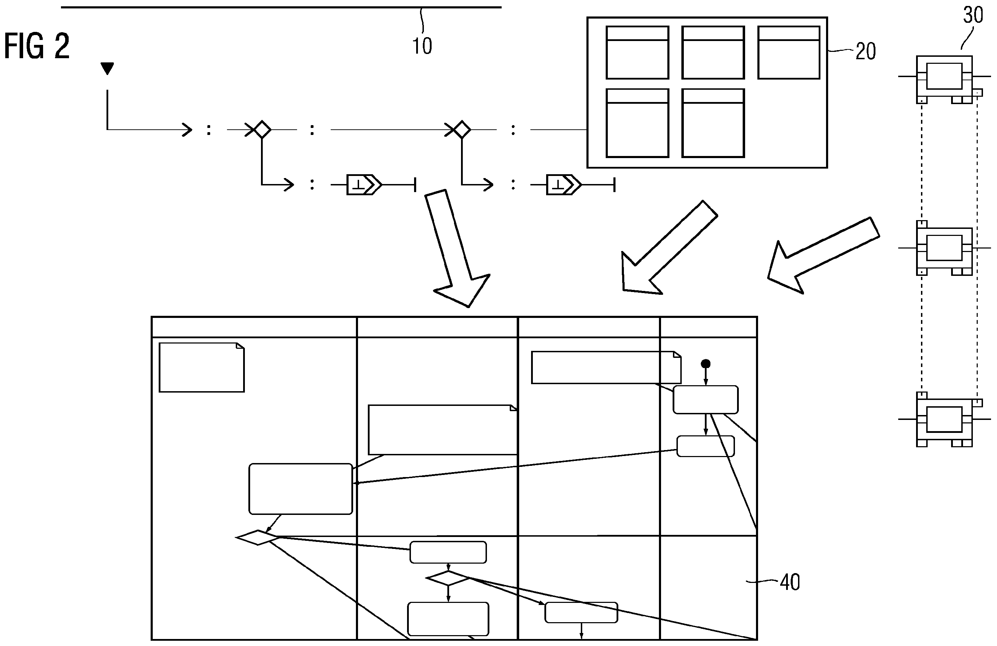

Figure 1 illustrates a flowchart of the method for generating the integration test model 40 according to the invention. In the first step S1, the communication means is provided, preferably a telegram, wherein the telegram is used for communication between the technical components of the technical system. In the second step S2, the respective technical component is assigned to the telegram by means of the respective control logic chart 10. In the third step S3, the system configuration is provided as the respective test environment 30. In a further step S4, the test data model 20 is provided. The input data, the telegram, the test data model 20 and the test environment 30 is shown in Figure 2.

In a further step S5, the integration test model 40 is generated based on the telegram, the test environment 30 and the test data model 20. The information of the respective control logic chart 10 is considered with regard to the telegram. The resulting integration test model 40 is shown in Figure 2. In the last step S6, the integration test model 40 is provided as output S6.

The integration test model 40 refers to integration testing, in more detail to integration of functionality that spans over multiple technical components which communicate via external telegrams or internal triggers.

### Input data

According to an embodiment, the telegram which the technical components use to interact with each other can be selected S1. It is determined which technical components handle this telegram, preferably from the system behavior model (e. g. in Sims W sequence charts, SEC).

According to an embodiment, the system configuration is deduced from the telegrams interaction and the operational context identified. Then, the relevant test environment 30 can be determined manually (based on expert knowledge) or automatically S3. In the latter case, it can be tool supported. Thereby, the technical components and the constraints are defined as well as choices for the technical component characteristics and the topology. Then, a list of all system configurations can be generated that satisfy these requirements. These system configurations are then used as a test environment.

According to an embodiment, the instantiation of the test environments can be realized in different ways, as follows:
i. building a separate test environment for each system configuration identified.
ii. Building one (possibly large) test environment as the superset of all system configurations identified.
iii. Building an "unconnected" test environment that includes the required technical components (e.g. maximum number of each technical component type over all system configurations identified).

Then, for each concrete test environment the required technical components as defined by the respective system configuration are connected. The test environments can be optimized according to e.g. the maximal independence or minimal maintenance effort.

Accordingly, the separate and specifically designed test environments for a test case can ensure that there are no interferences from e. g. the technical components not needed for the test. On the downside having to manage many test environments can be a significant additional effort, especially when the tests are to be executed on real Hardware.

Accordingly, the shared environment might introduce dependencies between tests, obscuring which aspects of the test environment are required for any individual test. On the other hand less effort is needed to maintain shared test environments.

### Generation of the integration test model

According to an embodiment, for each telegram, which is sent by a technical component, the information from the control logic chart (including e.g. the control flow, the telegrams transmitted via interfaces/ports) and the test environment 30 is used to generate the corresponding integration test model 40.

The information of the control flow is incorporated into the integration test model 40 from the control logic chart and the test data model 20, to determine the test stimuli for individual test paths to be taken.

It is started with a telegram, which is sent by a technical component. Then, the telegram is followed until no further telegrams are created in the given context. Additionally, all further triggered internal triggers and external telegrams can be followed.

According to an embodiment, for test environments and control flows that potentially allow for cyclic telegram flows criteria are defined when the flows shall be stopped.

Moreover, according to an embodiment, the integration test model can be analyzed and e.g. extended with conditions for each possible flow. The extension can be based on the control logic charts of the technical components, which are involved.

Moreover, according to an embodiment, the test goals for the test generation can be formulated via e.g. coverage criteria for the transitions of the integration test model and for data choices according to the test data model.

Moreover, according to an embodiment, the integration test model can be used to generate executable tests. The executable tests can be generated as optimal test suites according to the test goals. Therefore, relevant operational scenarios are defined. Then, the test environment and test data model are defined. Then, the initial integration test model is generated. The test model is extended with decisions and control flow paths based on possible choices according to test data model and test environment. Abstract tests (test steps, test stimuli) are generated for signal integration. Then, a test code generation step is utilized to create executable tests of the system.

## Claims

1. Computer-implemented method for generating an integration test model (40), comprising the steps:
a. Providing at least one communication means, wherein the at least one communication means is used for communication between a plurality of technical components of a technical system (S1); wherein the plurality of technical components communicate information with each other by means of telegrams; wherein
the telegrams are sent and received by the technical component at its defined ports;
b. Assigning at least one respective technical component of the plurality of technical components to the at least one communication means by means of at least one respective control logic chart (10) (S2); wherein
the at least one respective control logic chart (10) describes a behavior of the plurality of technical components comprising a reaction that a received telegram will trigger within the technical component, which other telegrams are sent as a result and whether the telegram is stopped or forwarded at a defined port;
c. providing at least one system configuration as at least one test environment (30) (S3) for testing an integration scenario, wherein the plurality of technical components are connected in a defined system configuration;
d. providing a test data model (20) (S4);
e. generating the integration test model (40) based on the at least one communication means, the at least test environment (30) and the test data model (20) (S5); wherein
information of the respective control logic chart (10) is considered with regard to the at least one communication means; and
f. providing the integration test model (40) (S6) in order to generate integration test cases and executable test scripts for automated testing.

2. Computer-implemented method according to claim 1,
wherein providing the at least one system configuration as at least one test environment (30) comprises
- Providing a plurality of test environments by generating a respective test environment for each system configuration of a plurality of system configurations;
- Providing one test environment for a plurality of system configurations; or
- Providing at least one configured test environment considering at least one requirement.

3. Computer-implemented method according to claim 1 or claim 2, wherein the information is information of a control flow.

4. Computer-implemented method according to any of the preceding claims, wherein considering information of the respective control logic chart, comprises Starting with the at least one communication means communicated by the at least one technical component; Following the at least one communication means, at least one triggered internal trigger and/or at least one external communication means until all distinct sets of telegrams are created in the given context.

5. Computer-implemented method according to any of the preceding claims, further comprising
- Analysing the integration test model (40); and/or
- Adapting the integration test model (40).

6. Computer-implemented method according to any of the preceding claims, further comprising generating at least one executable test according to at least one test goal based on the integration test model (40).

7. Computer-implemented method according to claim 6, further comprising executing the at least one executable test in the at least one test environment to generate at least one test result.

8. Computer-implemented method according to claim 7, further comprising
- triggering at least one measure depending on the at least one test result to reach a safe state;
- storing the at least one test result in a storage unit; and/or
- transmitting the at least one test result and/or any other related notification to a computing unit.

9. A computer program product directly loadable into an internal memory of a computer, comprising software code portions for performing the steps according to any one of the preceding claims when said computer program product is running on a computer.

10. Technical system for performing the method according to claims 1 - 8.

## Patentansprüche

1. Computergestütztes Verfahren zum Generieren eines Integrationstestmodells (40) mit folgenden Schritten:
a. Bereitstellen mindestens eines Kommunikationsmittels, wobei das mindestens eine Kommunikationsmittel für die Kommunikation zwischen mehreren technischen Komponenten eines technischen Systems benutzt wird (S1), wobei die mehreren technischen Komponenten mithilfe von Telegrammen Informationen miteinander austauschen, wobei
die Telegramme von der technischen Komponente an ihren definierten Anschlüssen gesendet und empfangen werden,
b. Zuordnen mindestens einer jeweiligen der mehreren technischen Komponenten zu dem mindestens einen Kommunikationsmittel mithilfe mindestens eines jeweiligen Steuerlogikdiagramms (10) (S2), wobei das mindestens eine jeweilige Steuerlogikdiagramm (10) ein Verhalten der mehreren technischen Komponenten beschreibt, einschließlich einer Reaktion, die von einem empfangenen Telegramm in der technischen Komponente ausgelöst wird, welche anderen Telegramme infolgedessen gesendet werden und ob das Telegramm an einem definierten Anschluss gestoppt oder weitergeleitet wird,
c. Bereitstellen mindestens einer Systemkonfiguration als mindestens eine Testumgebung (30) (S3) zum Testen eines Integrationsszenarios, wobei die mehreren technischen Komponenten in einer definierten Systemkonfiguration verbunden sind,
d. Bereitstellen eines Testdatenmodells (20) (S4),
e. Generieren des Integrationstestmodells (40) auf der Grundlage des mindestens einen Kommunikationsmittels, der mindestens einen Testumgebung (30) und des Testdatenmodells (20) (S5), wobei
Informationen im jeweiligen Steuerlogikdiagramm (10) in Bezug auf das mindestens eine Kommunikationsmittel berücksichtigt werden und
f. Bereitstellen des Integrationstestmodells (40) (S6) zwecks Generierens von Integrationstestdatensätzen und ausführbaren Testskripten für das automatische Testen.

2. Computergestütztes Verfahren nach Anspruch 1, wobei das Bereitstellen der mindestens einen Systemkonfiguration als mindestens eine Testumgebung (30) Folgendes umfasst:
- Bereitstellen mehrerer Testumgebungen durch Generieren einer jeweiligen Testumgebung für jede von mehreren Systemkonfigurationen,
- Bereitstellen einer Testumgebung für mehrere Systemkonfigurationen oder
- Bereitstellen mindestens einer konfigurierten Testumgebung unter Berücksichtigung mindestens einer Bedingung.

3. Computergestütztes Verfahren nach Anspruch 1 oder 2, wobei es sich bei den Informationen um Informationen in einem Steuerfluss handelt.

4. Computergestütztes Verfahren nach einem der vorhergehenden Ansprüche, wobei das Berücksichtigen von Informationen in dem jeweiligen Steuerlogikdiagramm Folgendes umfasst:
Beginnen mit dem mindestens einen Kommunikationsmittel, das von der mindestens einen technischen Komponente übermittelt wird,
auf das mindestens eine Kommunikationsmittel folgend mindestens ein ausgelöster interner Auslöser und/oder mindestens ein externes Kommunikationsmittel, bis alle eindeutigen Sätze von Telegrammen im gegebenen Kontext erstellt sind.

5. Computergestütztes Verfahren nach einem der vorhergehenden Ansprüche, das ferner Folgendes umfasst:
- Analysieren des Integrationstestmodells (40) und/oder
- Anpassen des Integrationstestmodells (40).

6. Computergestütztes Verfahren nach einem der vorhergehenden Ansprüche, das ferner das Generieren mindestens eines ausführbaren Tests entsprechend mindestens einem Testziel auf der Grundlage des Integrationstestmodells (40) umfasst.

7. Computergestütztes Verfahren nach Anspruch 6, das ferner das Ausführen des mindestens einen ausführbaren Tests in der mindestens einen Testumgebung zwecks Generierens mindestens eines Testergebnisses umfasst.

8. Computergestütztes Verfahren nach Anspruch 7, das ferner Folgendes umfasst:
- Auslösen mindestens einer Maßnahme in Abhängigkeit von dem mindestens einen Testergebnis zwecks Erreichens eines sicheren Zustands,
- Speichern des mindestens einen Testergebnisses in einer Speichereinheit und/oder
- Übertragen des mindestens einen Testergebnisses und/oder beliebiger anderer zugehöriger Meldungen zu einer Recheneinheit.

9. Computerprogrammprodukt, das direkt in einen internen Arbeitsspeicher eines Computers geladen werden kann und Softwarecodeteile für das Durchführen der Schritte nach einem der vorhergehenden Ansprüche umfasst, wenn das Computerprogrammprodukt auf einem Computer ausgeführt wird.

10. Technisches System zum Durchführen des Verfahrens nach Anspruch 1 - 8.

## Revendications

1. Procédé mis en œuvre par ordinateur pour générer un modèle de test d'intégration (40), comprenant les étapes de :
a. fourniture d'au moins un moyen de communication, dans lequel l'au moins un moyen de communication est utilisé pour la communication entre une pluralité de composants techniques d'un système technique (S1) ; dans lequel la pluralité de composants techniques communiquent des informations entre eux par télégrammes ; dans lequel
les télégrammes sont envoyés et reçus par le composant technique au niveau de ses ports définis ;
b. affectation d'au moins un composant technique respectif de la pluralité de composants techniques à l'au moins un moyen de communication par au moins un diagramme de logique de contrôle respectif (10) (S2) ; dans lequel
l'au moins un diagramme de logique de contrôle respectif (10) décrit un comportement de la pluralité de composants techniques comprenant une réaction qu'un télégramme reçu déclenchera au sein du composant technique, les autres télégrammes qui sont envoyés en conséquence et si le télégramme est arrêté ou transféré au niveau d'un port défini ;
c. fourniture d'au moins une configuration système en tant qu'au moins un environnement de test (30) (S3) pour tester un scénario d'intégration, dans lequel la pluralité de composants techniques sont connectés selon une configuration système définie ;
d. fourniture d'un modèle de données de test (20) (S4) ;
e. génération du modèle de test d'intégration (40) sur la base de l'au moins un moyen de communication, de l'au moins un environnement de test (30) et du modèle de données de test (20) (S5) ; dans lequel
les informations du diagramme de logique de contrôle respectif (10) sont prises en compte au regard de l'au moins un moyen de communication ; et
f. fourniture du modèle de test d'intégration (40) (S6) afin de générer des cas de test d'intégration et des scripts de test exécutables pour les tests automatisés.

2. Procédé mis en œuvre par ordinateur selon la revendication 1, dans lequel la fourniture de l'au moins une configuration système en tant qu'au moins un environnement de test (30) comprend
- la fourniture d'une pluralité d'environnements de test en générant un environnement de test respectif pour chaque configuration système d'une pluralité de configurations système ;
- la fourniture d'un environnement de test pour une pluralité de configurations système ; ou
- la fourniture d'au moins un environnement de test configuré en tenant compte d'au moins une exigence.

3. Procédé mis en œuvre par ordinateur selon la revendication 1 ou la revendication 2, dans lequel les informations sont des informations concernant un flux de contrôle.

4. Procédé mis en œuvre par ordinateur selon l'une des revendications précédentes, dans lequel, la prise compte des informations du diagramme de logique de contrôle respectif comprend
le démarrage avec l'au moins un moyen de communication communiqué par l'au moins un composant technique ;
le suivi de l'au moins un moyen de communication, de l'au moins un déclencheur interne déclenché et/ou de l'au moins un moyen de communication externe, jusqu'à la création de tous les ensembles distincts de télégrammes dans le contexte donné.

5. Procédé mis en œuvre par ordinateur selon l'une des revendications précédentes, comprenant en outre
- l'analyse du modèle de test d'intégration (40) ; et/ou
- l'adaptation du modèle de test d'intégration (40).

6. Procédé mis en œuvre par ordinateur selon l'une des revendications précédentes, comprenant en outre la génération d'au moins un test exécutable conformément à au moins un objectif de test basé sur le modèle de test d'intégration (40).

7. Procédé mis en œuvre par ordinateur selon la revendication 6, comprenant en outre l'exécution de l'au moins un test exécutable dans l'au moins un environnement de test afin de générer au moins un résultat de test.

8. Procédé mis en œuvre par ordinateur selon la revendication 7, comprenant en outre
- le déclenchement d'au moins une mesure en fonction de l'au moins un résultat de test, afin d'atteindre un état sûr ;
- le stockage de l'au moins un résultat de test dans une unité de stockage ; et/ou
- la transmission de l'au moins un résultat de test et/ou de toute autre notification associée à une unité de calcul.

9. Produit de programme informatique directement chargeable dans la mémoire interne d'un ordinateur, comprenant des portions de code logiciel pour réaliser les étapes selon l'une quelconque des revendications précédentes lorsque ledit produit de programme informatique est exécuté sur un ordinateur.

10. Système technique pour réaliser le procédé selon les revendications 1-8.
